# EUROPÄISCHE PATENTSCHRIFT

(11) **EP 2 283 371 B1**
(45) Veröffentlichungstag und Bekanntmachung des Hinweises auf die Patenterteilung: **26.09.2012**
(21) Anmeldenummer: 09749381.1
(22) Anmeldetag: 12.05.2009
(51) Int. Cl.: G01D 4/00

(54) **LEISTUNGSMESSVORRICHTUNG**
POWER MEASURING DEVICE
DISPOSITIF DE MESURE DE LA PUISSANCE

(30) Priorität: 23.05.2008 CH 780082008
(43) Veröffentlichungstag der Anmeldung: 16.02.2011
(73) Patentinhaber: Gloor Engineering, 7434 Sufers (CH)
(72) Erfinder: GLOOR, Rolf, CH-7434 Sufers (CH); TANNER, Ronald, CH-4123 Allschwil (CH)
(74) Vertreter: Rentsch Partner AG
(86) Internationale Anmeldenummer: PCT/CH2009/000155
(87) Internationale Veröffentlichungsnummer: WO 2009/140777

(56) Entgegenhaltungen:
- WO-A-2007/143834
- US-A1- 2005 083 206
- US-B1- 6 226 600

## Beschreibung

### Technisches Gebiet

Die vorliegende Erfindung bezieht sich auf das Gebiet der elektrischen Messtechnik; sie betrifft eine Messvorrichtung zur Erfassung von elektrischer Leistung, die von einem oder mehreren Verbrauchern konsumiert wird.

### Technologischer Hintergrund

Für die Messung von elektrischer Leistung und Energie gibt es eine grosse Anzahl von unterschiedlichen Geräten. Bei der temporären Leistungsmessung in einem Drehstromnetz, zum Beispiel für eine Stromverbrauchsanalyse, werden für die Messung des elektrischen Stroms Stromzangen um die elektrischen Leiter gelegt und gleichzeitig die Spannung abgegriffen. Das Messgerät errechnet aus diesen Grössen die aktuelle elektrische Leistung und kann je nach Ausführung diese Werte aufzeichnen (Logger) und weitere Grössen, wie die Netzqualität, ermitteln.

Bei der praktischen Messung ist ein grosses Problem der Spannungsabgriff. Zum einen sind in zeitgemässen Schaltschränken alle unter Spannung stehenden Kontaktflächen abgedeckt, zum anderen ist nach der Entfernung der Abdeckungen die Anbringung von Klemmen oder Kontaktstiften schwierig, da kaum passende Kontaktstellen zur Verfügung stehen. Solche Messungen finden auch in unter Spannung stehenden Anlagen statt. Manipulationen mit entfernten Abdeckungen sind gefährlich, zum einen können die Personen mit unter Spannung stehenden Teilen in Kontakt kommen und dadurch schweren gesundheitlichen Schaden nehmen, zum andern kann durch die Hantierung ein Kurzschluss ausgelöst werden, welcher einen Anlageschaden und eventuell auch einen teuren Produktionsausfall verursacht.

Ein weiteres Problem besteht in der Zuordnung von Leiterströmen und zugehörigen Leiterspannungen. Für die Leistungsmessung der einzelnen Phasen muss zu jeder Phasenspannung auch der entsprechende Strom in der richtigen Richtung gemessen werden. Wegen der Probleme mit dem Spannungsabgriff kann es vorkommen, dass diese Zuordnung falsch erfolgt und man gegebenenfalls den Fehler nicht feststellt oder mit einer zweiten Messung korrigieren werden muss.

Eine weitere Fehlerquelle stellt die Kalibrierung von Leistungsmessgeräten dar; da es für die meisten Leistungsmessgeräte unterschiedliche Sensoren oder Abgriffe gibt, ist die Verwendung eines falschen Umrechnungsfaktors eine weitere mögliche Fehlerquelle.

Die am Markt erhältlichen Leistungsmessgeräte sind entweder für eine einphasige oder dreiphasige Leistungsmessung. Bei umfassenden Stromverbrauchsanalysen wäre es aber wünschenswert, wenn gleichzeitig mehrere Verbraucher detailliert gemessen werden könnten. Dazu sind heute mehrere konventionelle Leistungsmessgeräte erforderlich.

Ein weiteres Problem besteht in der räumlichen Trennung zwischen einer Verbraucheranlage und der zugehörigen Messstelle, welche sich meistens im entfernten Schaltschrank befindet Für die optimale Interpretation einer Messung wäre es wünschenswert, direkt an der Verbraucheranlage die aktuellen Messresultate zur Verfügung zu haben und einem Prozess zuzuordnen.

Bei umfassenden Energieanalysen werden zusätzlich zur Leistungsmessung weitere Messgrössen wie Temperatur, Druck, Geschwindigkeit usw. erfasst. Heute werden dazu verschiedene unterschiedliche Messgeräte verwendet, deren zeitgleiche Auswertung und Darstellung aufwendig ist.

DE 692 23 014 T2 offenbart eine Leistungsmessvorrichtung in Form eines Multimeters mit Strommesszange und Anschlussklemmen zwecks Messung des einen Leiter durchströmenden Stroms und der zugehörigen Leiterspannung. Aus den erhaltenen Messwerten für Strom und Spannung ermittelt das Multimeter auch Leistungswerte oder Energiewerte.

Auch US 6,043,640 beschreibt ein solches, konventionelles Multimeter, das mittels Stromzange und zugehörigen Messsonden Strom und Spannung eines Leiters erfassen und gewünschte elektrische Kerngrössen bestimmen und anzeigen kann.

US 6,226,600 stellt ein benutzerfreundliches System zur -privaten, nicht verrechenbaren-Überwachung des Elektrizitätsverbrauchs dar, bei der eine Messungsübertragungseinheit Strommesswerte an eine von dieser Messungsübertragungseinheit entfernt angeordneten, programmierbare Empfangs- und Anzeigeeinheit überträgt. Hierfür sind separate Stromwandler sekundärseitig eines zur Verrechnung installierten Elektrizitätszählers in der Nähe eines Sicherungskastens an Leitungen angeordnet, die den darin fliessenden Strom erfassen. Die Strommesswerte werden mit Hilfe einer Kommunikationseinheit von der Messungsüber tragungseinheit zu der entfernt angeordneten Empfangs- und Anzeigeeinheit übertragen und dort dargestellt. In dieser Empfangs- und Anzeigeeinheit wird neben den Stromwerten ebenfalls ein Leistungswert oder Energiewert angezeigt, wobei die Stromwerte mit einem vorgängig gespeicherten Spannungswert und einem gespeicherten Leistungsfaktorwert multipliziert werden, das heisst, die Spannung wird nicht gemessen, sondern als fix angenommen. Die gespeicherten Spannungswerte sind anpassbar bzw. umprogrammierbar, wobei aber der Tatsache Rechnung getragen wird, dass die Spannung in einem Verbundnetzwerk grundsätzlich derart geringen Schwankungen unterliegt, so dass ein fix programmierter Spannungswert berücksichtigt werden kann, ohne nennenswerte Fehlberechnungen zu machen. Hingegen ist der Leistungsfaktorwert, der den Phasenwinkel zwischen Strom und Spannung abbildet, unveränderbar als Festwert vorgegeben, da dieser als einheitlich angenommen wird. Solche Messungen erlauben in ausgewählten Fällen eine gute Abschätzung eines Elektrizitätsverbrauchs, im Allgemeinen entsprechen die gewonnen Daten aber nicht der Realität und sind somit lediglich eingeschränkt aussagekräftig.

Diese in Rede stehende Patentschrift erwähnt nebenbei, dass auf Wunsch die Spannung ebenfalls messbar ist, und zwar an Klemmen in der Nähe der Stromwandler und der Messungsübertragungseinheit, die am angegebenen Ort installiert ist. In diesem Fall müsste die Messungsübertragungseinheit nicht nur die Stromwerte an die Empfangs- und Anzeigeeinheit übertragen, sondern darüber hinaus zusätzlich erfassten Spannungswerte und den Phasenwinkel.

Allen bekannten Leistungsmessvorrichtungen ist gemeinsam, dass eine Spannungsmessung mittels Messsonden, Messspitzen oder direkt angeschlossenen Messkabeln erfolgen muss; das heisst, dass Spannung führende Kontakte mit Messsonden oder Messspitzen versehen werden müssen oder spannungsfrei geschaltete Kontakte geschaffen werden müssen, um Messkabel zu installieren; ersteres bedarf sehr sorgfältiges Arbeiten wegen der bekannten gesundheitlichen Gefährdung, letzteres bedeutet, dass zu überwachende Verbraucher abgeschaltet und wieder angefahren werden müssen, was zu entsprechenden Produktionsausfällen oder zumindest Nutzungsausfällen führen kann.

### Darstellung der Erfindung

Ausgehend von diesem Stand der Technik besteht die Aufgabe der vorliegenden Erfindung darin, eine Leistungsmessvorrichtung anzugeben, die für umfassende Stromverbrauchsanaly se eine genaue Leistungsmessung ermöglicht, wobei diese Leistungsmessvorrichtung völlig spannungsberührungssicher auch bei in Betrieb befindlichen Anlagen oder Geräten installierbar ist.

Die dieser Erfindung zugrunde liegende Aufgabe wird gelöst durch eine Leistungsmessvorrichtung gemäss dem Patentanspruch 1. Vorteilhafte Ausgestaltungen dieser Leistungsmessvorrichtung sind Gegenstand der Unteransprüche 2 bis 8 oder lassen sich der nachfolgenden Beschreibung sowie den Ausführungsbeispielen entnehmen.

Kern der vorliegenden Erfindung ist, dass bei einer elektrischen Leistungsmessvorrichtung ein Strommesssensor, der an einer Strom führenden Leitung eines elektrischen Verbrauchers in einen Elektrizitätsverteilnetzes angeordnet ist, mit einem Strommessgerät verbunden ist, während ein Spannungsmessgerät ortsfern dieser Leitung in dem Elektrizitätsnetzwerk zwecks Spannungsmessung in eine Steckdose einsteckt ist. Hierdurch ist eine besonders einfache Installation der Leistungsmessvorrichtung möglich, die darüber hinaus völlig spannungsberührungssicher -insbesondere auch für die Erfassung der Spannungsmesswerteeingerichtet werden kann.

Mittels einer Zeitsynchronisationseinheit in dem Strommessgerät, bzw. dem Spannungsmessgerät werden beide Geräte synchronisiert, damit eine exakte Zuordnung der Strommesswerte zu den Spannungsmesswerten erfolgen kann. Über eine Kommunikationsschnittstelle werden beide Geräte synchronisierbar und ihre Messwerte können einer Datensammelvorrichtung zugeführt werden, zwecks unmittelbarer oder späterer, gemeinsamer Weiterverarbeitung zu den bekannten elektrischen Kenngrössen einer Verbrauchserfassung.

Für die Messung der elektrischen Leistung werden Strom und Spannung separat, d. h. mit getrennt voneinander ausgeführten, zeitsynchronisierten Messgeräten gemessen und/oder aufgezeichnet. Da in einem lokalen Versorgungsnetz hinter einem Hochspannungstransformator die Netzspannung überall gleich ist, kann neben der Stromverbrauchserfassung einer Anlage die Spannung erfindungsgemäss auch an einer in dem lokalen Versorgungsnetz vorhandenen Steckdose mit minimalem Aufwand und ohne Gefahr gemessen werden. Für eine Berechnung der Leistung sind die zeitgleichen Informationen über den Verlauf der Spannung und des entsprechenden Stroms erforderlich.

Diese Informationen können zum Beispiel über eine Datenverbindung (Stromnetz, Kabel, Funknetz usw.) direkt übermittelt werden. So kann die Spannungsmessung ihre Grössen an die Strommessung übertragen und dort kann aus den lokal gemessen Grössen die Leistung berechnet werden. Die Übermittlung kann auch umgekehrt erfolgen, dass bei der Spannungsmessung die Stromdaten eintreffen. Die Werte aus der Strom- und Spannungsmessung können auch an ein drittes System übermittelt werden, wo dann die Leistungsberechnung erfolgt.

Wenn der Strom- und die Spannungsmessung mit der Information über die Zeit aufgezeichnet werden, kann die Übermittelung und Leistungsberechnung auch später erfolgen.

Da im Drehstromsystem die drei Phasen ziemlich genau um 120 ° phasenverschoben und die Amplituden etwa gleichgross sind, kann aus der Spannungsmessung von einer Phase die der andern beiden Phasen errechnet werden. Die für die Leistungsmessung erforderliche Zuordnung von Strom und Spannung einer Phase kann über eine plausible Zuordnung eines zu erwartenden Bereiches der Wirk- und Blindleistung erfolgen. Bei einer Aufzeichnung der Strom- und Spannungsmessungen kann die Phasenzuordnung später jederzeit korrigiert werden.

Zur sicheren Zuordnung der entsprechenden Phase kann bei einer Strommessung mit einem eingebauten Tastkopf eine kapazitive Kopplung zum Leiter hergestellt werden. Mit dieser zusätzlichen Information über den Spannungsverlauf im Leiter gegenüber der Erde kann dem Leiter eindeutig einer Phase zugeordnet werden, wenn sich der Nulleiter in der Nähe des Erdpotentials befindet, was im allgemeinen zu erwarten ist

Unabhängig von der Anzahl Strommessungen braucht es notwendigerweise zumindest eine Spannungsmessung einer Phase. Zur Erhöhung der Genauigkeit, können auch alle drei Phasenspannungen gemessen werden. Bei Betrieben mit mehreren Netzspannungen (Notstromnetz, 500 V-Netz usw.) kann die Spannung dieser Netze zusätzlich gemessen werden und den entsprechenden Strömen zugeordnet werden.

Bei einer Übertragung mit Funk kann zum Beispiel ein sich selbst konfigurierendes Funknetzwerk eingesetzt werden. Im Schaltschrank kann ein flacher Antennenstummel in die geschlossene Schaltschranktüre eingeklemmt werden. Für die Funkübertragung entfernter Messstellen oder zur Anlage können "Repeater" eingesetzt werden. Computer, PDA oder Handys können als Mensch-Maschine-Schnittstelle dienen und in das Funksystem online und oder offline mit einbezogen werden.

Das Messsystem für elektrische Leistung kann auch mit zusätzlichen Sensoren (Temperatur, Strömungsgeschwindigkeit, Druck usw.) erweitert werden oder für andere Aufgaben verwendet werden.

Die Messsensoren können mit einer eigenen Elektronik ausgerüstet sein. Zum einen sind die Sensordaten (Serienummer, Sensorname, Messeinheiten, Genauigkeit, Kalibrierung usw.) abgespeichert, zum andern kann über ein Display auch die Messstelle, die Messgrösse sowie weitere Daten angezeigt werden. Der Name der Messstelle kann dem Sensor über eine oben genannte Mensch-Maschinen-Schnittstelle zugeordnet werden. Bei einer Stromzange könnte zudem das Öffnen der Zange registriert werden um eine mögliche Änderung der Messstelle zu erkennen.

### Kurze Beschreibung der Zeichnung

In der Zeichnung sind mehrere Ausführungsbeispiele der Erfindung vereinfacht dargestellt, und zwar zeigen
- Fig. 1: ein Schaltschema einer erfindungsgemässen Leistungsmessvorrichtung mit einer einphasigen Strommessung und Spannungsmessung;
- Fig. 2: eine weitere Ausführungsform der Leistungsmessvorrichtung mit einer dreiphasigen Strommessung und einer einphasigen Spannungsmessung, und
- Fig. 3: eine weitere Ausführungsform der Leistungsmessvorrichtung mit einer dreiphasigen Strom- und Spannungsmessung.

### Wege zur Ausführung der Erfindung

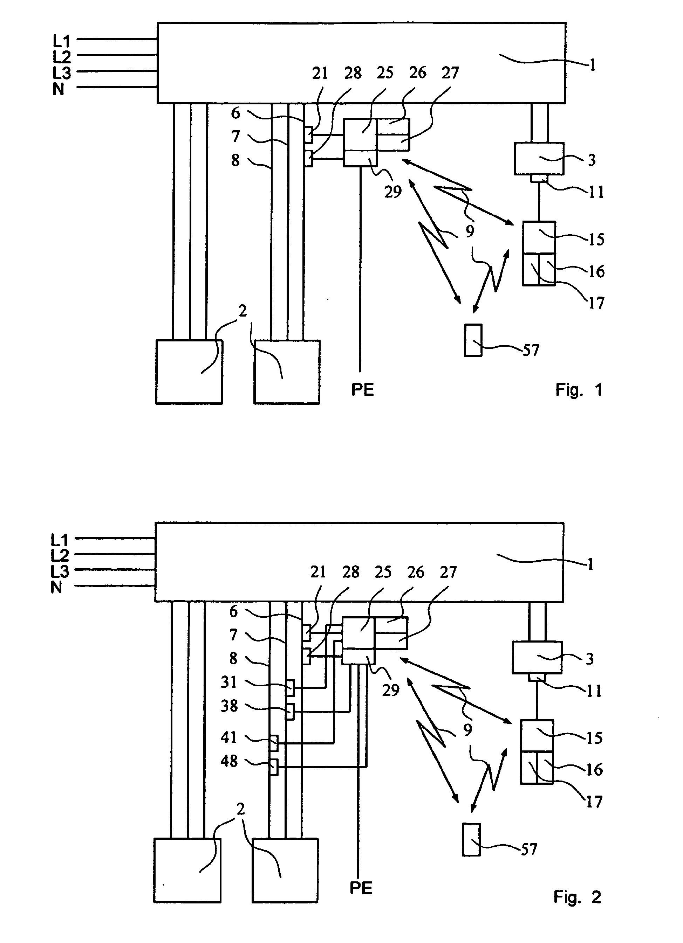

In Fig. 1 wird ein Verbraucher 2 aus einem Elektrizitätsverteilnetz 1 über Leitungen 6, 7, 8 mit Energie versorgt. Dieses Elektrizitätsverteilnetz 1 wird aus einem übergeordneten Netz mittels der Leitungen L1, L2, L3, (N) gespeist und kann als ein in sich geschlossenes Verteilnetz angesehen werden; d. h., die jeweiligen Leiterspannungen der Leitungen L1, L2, L3 und der den zugehörigen Phasen entsprechenden Leitungen 6, 7, 8 sind innerhalb dieses Elektrizitätsverteilnetzes 1 gleich, so dass eine Spannungsmessung der Leiterspannungen überall in diesem Elektrizitätsverteilnetz 1 zu jeweils dem gleichen Ergebnis führt.

Ein galvanisch getrennt an die Leitung 6 gekoppelter Strommesssensor 21 erfasst den Strom in dieser Leitung 6 zum Verbraucher 2, wobei dieser Strommesssensor 21 verbunden ist mit einem Strommessgerät 25. Über eine Schnittstelle 9 ist das Strommessgerät 25 zwecks Datenaustausch mit einem Spannungsmessgerät 15 verbunden. Diese Schnittstelle 9 kann als drahtgebundene Schnittstelle ausgebildet sein oder als eine Funkschnittstelle; da einem einschlägigen Fachmann die Ausbildung einer solchen Schnittstelle 9 geläufig ist und selbige nicht Gegenstand vorliegender Erfindung ist, wird hier nicht detailliert auf diese eingegangen.

Dieses Spannungsmessgerät 15 erfasst erfindungsgemäss eine Leiterspannung 11 des Elektrizitätsverteilnetzes 1 an einer Steckdose 3, die an einem beliebigen Ort innerhalb des Elektrizitätsverteilnetzes 1 installiert sein kann; die Messung der Leiterspannung 11 erfolgt somit ortsfern der Strommessung durch Strommesssensor 21 an der Leitung 6.

Das Strommessgerät 25 weist eine Synchronisationseinheit 26 auf und das Spannungsmessgerät 15 eine Synchronisationseinheit 16, worüber beide Messgeräte miteinander synchronisierbar sind. Des Weiteren kann das Strommessgerät eine Datensammelvorrichtung 27 umfassen und/oder das Spannungsmessgerät 15 eine Datensammelvorrichtung 17.

Um eine einfache Zuordnung der gemessenen Spannung 11 am Spannungsmessgerät 15 zur Spannung an der Leitung 6 des Verbrauchers 2 durchzuführen zu können, ist an dieser Leitung 6 ein Tastkopf 28 kapazitiv angekoppelt, zwecks Erfassung des Spannungsverlaufs in der Leitung 6. Da dieser Tastkopf 28 lediglich kapazitiv an die Leitung 6 ankoppelt, weist diese Verbindung -ebenfalls wie die oben beschriebene Strommessung- eine galvanische Trennung zum Leiter 6 auf. Der Tastkopf 28 ist über ein kapazitives Messgerät 29 mit Erdpotential - beispielsweise mit einem PE-Leiter- verbunden und erfasst somit den Spannungsverlauf in Leitung 6.

Des Weiteren kann eine externe Datensammelvorrichtung 57 vorgesehen sein, die mit einer drahtgebundenen Schnittstelle oder einer Funkschnittstelle Daten aus dem Stormmessgerät 25 und/oder dem Spannungsmessgerät 15 auslesen kann.

Fig. 2 zeigt eine weitere Ausführungsform der erfindungsgemässen Leistungsmessvorrichtung. Zusätzlich zu der in Fig. 1 gezeigten Strommessung mittels Strommesssensor 21 an der Leitung 6, werden die elektrischen Ströme in den weiteren Leitungen 7 und 8 durch die Strommesssensoren 31 bzw. 41 erfasst und an das Strommessgerät 25 geleitet. Des Weiteren umfasst diese Ausführungsform an der Leitung 7 einen weiteren Tastkopf 38 und an der Leitung 8 einen Tastkopf 48, die jeweils kapazitiv den Spannungsverlauf in den zugehörigen Leitungen erfassen und an das kapazitive Messgerät 29 weiterleiten.

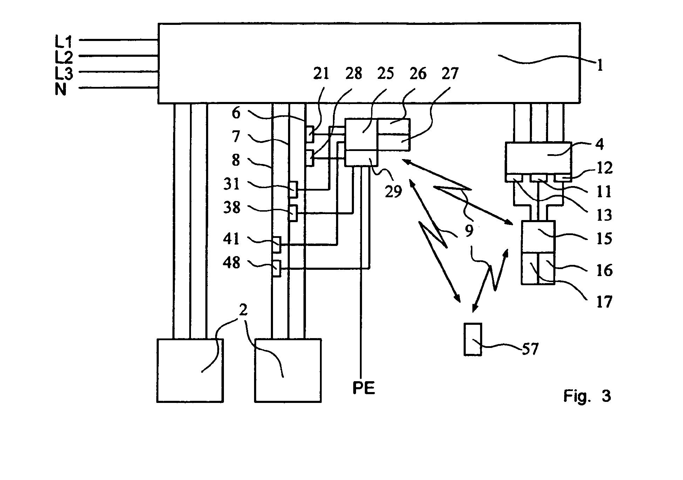

Die in Fig. 3 dargestellte erfindungsgemässe Ausführungsform unterscheidet sich von der vorherigen Ausführungsform in Fig. 2 durch eine dreiphasige Spannungsmessung. An einer

Steckdose 4 werden die Leiterspannungen 11, 12, 13 von allen drei Phasen eines Drehstromnetzes erfasst und an das Spannungsmessgerät 15 weitergegeben.

Für die Leistungsmessung eines Verbrauchers 2 wird zum einen der Strom in der Leitung 6 (Fig. 1), bzw. in den Leitungen 6, 7, 8 (Fig. 2, 3) gemessen, und zwar spannungsberührungssicher unter Einsatz galvanisch getrennter Strommesssensoren 21 bzw. 31, 41 und zum anderen die für die Leistungsmessung notwendige Spannung an einer Steckdose 3 bzw. 4. Vor dem Hintergrund, dass in einem Elektrizitätsverteilnetz 1 sekundärseitig eines hier nicht dargestellten Leistungstransformators die Phasenspannungen jeder einzelnen Phase überall etwa gleich ist, kann die Spannungsmessung an jedem Ort, also an jeder der Leitungen L1, L2, L3 untergeordneten Leitung im Elektrizitätsnetzwerk 1 gemessen werden. Erfindungsgemäss wird die Spannungsmessung durch Einstecken des Spannungsmessgeräts 15 an der Steckdose 3 bzw. 4 durchgeführt; d.h., dass die Spannungsmessung -wie die oben beschriebene Strommessung- spannungsberührungssicher auf einfache Art durchgeführt wird. Ein möglicher Fehler bei der Installation der Spannungsmessung kann somit ausgeschlossen werden und sie kann darüber hinaus vollkommen sicher -auch bei in Betrieb befindlichen Anlagen- erfolgen.

Die Messung des Stroms und der Spannung des Verbrauchers 2 wird zeitsynchron durchgeführt, wobei zumindest eines der Messgeräte -das Strommessgerät 25 oder das Spannungsmessgerät 15- mit einer Synchronisationseinheit 16, 26 ausgestattet sein muss. Beispielsweise können die Nulldurchgänge der gemessen Spannung am Spannungsmessgerät 15 für eine Synchronisierung der Strommessgeräts 25 genutzt werden, wofür zumindest dieses Strommessgerät 25 mit einer Synchronisationseinheit 26 ausgestattet sein muss.

Die Synchronisation erfolgt zwischen dem Strommessgerät 25 und Spannungsmessgerät 15 über die oben bereits angesprochene Kommunikationsschnittstelle 9. Des Weiteren werden Strommessdaten und Spannungsmessdaten über die Kommunikationsschnittstelle 9 in einer Datensammelvorrichtung 17, 27. 57 zusammengetragen; dabei ist es unerheblich, ob die Datensammelvorrichtung 17, 27, 57 vom Strommessgerät 25 bzw. vom Spannungsmessgerät 15 umfasst ist oder als allein stehende Einheit 57 ausgebildet ist. Dem Fachmann ist transparent, dass die in der Datensammelvorrichtung 17, 27, 57 vorliegenden Messdaten zur Bestimmung/Berechung sämtlicher elektrischer Kerngrössen genutzt werden kann und somit auch zur Leistungsbestimmung des Verbrauchers 2.

Grundsätzlich genügt für die Leistungsmessung die Strommessung an dem Strommesssensor 21 bzw. den Strommesssensoren 31, 41 und die Spannungsmessung an der Steckdose 3 bzw. 4; eine einfachere Zuordnung zwischen Strommesswerten und Spannungsmesswerten kann aber dann erfolgen, wenn zusätzlich mittels des Tastkopfs 28 bzw. der Tastköpfe 38, 48 der Spannungsverlauf in den Strom führenden Leitungen 6, 7, 8 erfasst wird.

Ohne den erfinderischen Grundgedanken zu verlassen, sind weitere Ausführungsformen denkbar, die der Fachmann vor dem Hintergrund der Beschreibung entwickeln kann; so ist beispielsweise denkbar, eine Vielzahl von innerhalb eines Elektrizitätsverteilnetzes verteilt angeordneten Verbrauchern durch Messung ihrer Speiseströme gleichzeitig zu überwachen, wobei ihre Speisespannung lediglich an einem einzigen Ort in einer Steckdose gemessen wird; diese Leistungsmessvorrichtung zeichnet sich dann ganz besonders durch ihre einfache, schnelle und vor allem sichere Installation aus.

### Bezugszeichenliste

- 1: Elektrizitätsverteilnetz
- 2: Verbraucher
- 3, 4: Steckdose
- 6, 7, 8: Leitung
- 9: Kommunikationsschnittstelle
- 11, 12, 13: Leiterspannung
- 15: Spannungsmessgerät
- 16: Synchronisationseinheit
- 17: Datensammelvorrichtung
- 21: Strommesssensor
- 25: Strommessgerät
- 26: Synchronisationseinheit
- 27: Datensammelvorrichtung
- 28: Tastkopf
- 29: kapazitives Messgerät
- 31: Strommesssensor
- 38: Tastkopf
- 41: Strommesssensor
- 48: Tastkopf
- 57: Datensammelvorrichtung
- PE: Erdung/Schutzleiter
- N: Neutralleiter/Nullleiter
- L1, L2, L3: Leitung

## Patentansprüche

1. Leistungsmessvorrichtung für eine genaue Leistungsmessung an in Betrieb befindlichen Anlagen oder Geräten, umfassend einen mit einem Strommessgerät (25) verbundenen Strommesssensor (21, 31, 41), der an einer Strom führenden Leitung (6, 7, 8) eines elektrischen Verbrauchers (2) eines Elektrizitätsverteilnetzes (1) angeordnet ist und ein Spannungsmessgerät (15), **dadurch gekennzeichnet dass** das Spannungsmessgerät (15) ortsfern der Leitung (6, 7, 8) in dem Elektrizitätsverteilnetz (1) zwecks Spannungsmessung (11, 12, 13) in eine Steckdose (3, 4) einsteckbar ist, wobei das Strommessgerät (25) und/oder das Spannungsmessgerät (15) jeweils eine Zeitsynchronisationseinheit (16, 26) umfassen, zwecks Durchführung einer synchronisier ten Messwerterfassung.

2. Leistungsmessvorrichtung nach Anspruch 1, **dadurch gekennzeichnet, dass** das Strommessgerät (25) und das Spannungsmessgerät (15) mittels einer Kommunikationsschnittstelle (9) verbunden sind, zwecks Synchronisation des Strommessgeräts (25) mit dem Spannungsmessgerät (15) und/oder zwecks Zusammenführung erfasster Messwerte.

3. Leistungsmessvorrichtung nach Anspruch 2, **dadurch gekennzeichnet, dass** mittels der Kommunikationsschnittstelle (9) die Messwerte des Strommessgeräts (25) und/oder des Spannungsmessgeräts (15) drahtgebunden oder per Funk übertragbar sind.

4. Leistungsmessvorrichtung nach einem der vorhergehenden Ansprüche 1 bis 3, **dadurch gekennzeichnet, dass** eine Datensammelvorrichtung (17, 27, 57) umfasst ist, mit der Messwerte des Strommessgeräts (25) und/oder des Spannungsmessgeräts (15) gesammelt und gespeichert werden können.

5. Leistungsmessvorrichtung nach Anspruch 4, **dadurch gekennzeichnet, dass** die Datensammelvorrichtung (17, 27, 57) als eigenständige Vorrichtung (57) ausgeführt ist, oder in dem Strommessgerät (25) oder dem Spannungsmessgerät (15) angeordnet ist.

6. Leistungsmessvorrichtung nach einem der vorhergehenden Ansprüche 1 bis 5, **dadurch gekennzeichnet, dass** mittels eines Tastkopfs (28, 38, 48) eine kapazitive Kopplung zu der Strom führenden Leitung (6, 7, 8) bereitstellbar ist, um den Spannungsverlauf in dieser Leitung (6, 7, 8) zu erfassen.

7. Leistungsmessvorrichtung nach Anspruch 6, **dadurch gekennzeichnet, dass** der Tastkopf (28, 38, 48) an dem Strommesssensor (21, 31, 41) angeordnet ist

## Claims

1. Power measuring device for an accurate power measurement at systems or equipment being in operation, comprising a current measuring sensor (21, 31, 41) connected to a current measuring device (25), disposed on a current carrying line (6, 7, 8) to an electrical device (2) of an electrical distribution network (1) and a voltage measuring device (15), **characterized in that** the voltage measuring device (15) can be inserted into a socket (3,4) at remote locations from the line (6, 7, 8) in the electricity distribution network (1) for the purpose of voltage measurement (11, 12, 13), wherein the current measuring device (25) and/or the voltage measuring device (15) each have a time synchronization unit (16, 26), for the purpose of carrying out a synchronized measured value logging.

2. Power measuring device according to claim 1, **characterized in that** the current measuring device (25) and the voltage measuring device (15) are connected by means of a communication interface (9), for the purpose of synchronization of the current measuring device (25) with the voltage measuring device (15) and/or for the purpose of combining recorded measured values.

3. Power measuring device according to claim 2, **characterized in that** by means of the communication interface (9) the measured values of the current measuring device (25) and/or the voltage measuring device (15) are transferable by wire or by radio.

4. Power measuring device according to any one of the preceding claims 1 to 3, **characterized in that** a data collecting device (17, 27, 57) is included, by which measured values of the current measuring device (25) and/or the voltage measuring device (15) can be collected and stored.

5. Power measuring device according to claim 4, **characterized in that** the data collecting device (17, 27, 57) is designed as a standalone device (57), or is disposed in the current measuring device (25) or the voltage measuring device (15).

6. Power measuring device according to one of the preceding claims 1 to 5, **characterized in that** by means of a probe (28, 38, 48) a capacitive coupling to the current carrying line (6, 7, 8) can be provided in order to detect the voltage pattern in this line (6, 7, 8).

7. Power measuring device according to claim 6, **characterized in that** the probe (28, 38, 48) is disposed on the current measuring sensor (21, 31, 41).

## Revendications

1. Dispositif de mesure de puissance pour une mesure précise de la puissance électrique sur des installations ou appareils en fonctionnement, comprenant un capteur de mesure de courant (21, 31, 41), relié à un appareil de mesure de courant (25) et disposé sur une ligne conductrice de courant (6, 7, 8) d'un consommateur électrique (2) d'un réseau de distribution d'électricité (1), et un appareil de mesure de tension (15), **caractérisé en ce que** l'appareil de mesure de tension (15) peut, afin de mesurer la tension électrique (11, 12, 13), être enfiché dans une prise femelle (3, 4) à distance de la ligne (6, 7, 8) dans le réseau de distribution d'électricité (1), sachant que l'appareil de mesure de courant (25) et/ou l'appareil de mesure de tension (15) comprennent respectivement une unité de synchronisation temporelle (16, 26), afin d'effectuer une acquisition synchronisée des valeurs de mesure.

2. Dispositif de mesure de puissance selon la revendication 1, **caractérisé en ce que** l'appareil de mesure de courant (25) et l'appareil de mesure de tension (15) sont reliés au moyen d'une interface de communication (9), pour la synchronisation de l'appareil de mesure de courant (25) avec l'appareil de mesure de tension (15) et/ou pour le regroupement des valeurs de mesure acquises.

3. Dispositif de mesure de puissance selon la revendication 2, **caractérisé en ce qu'**au moyen de l'interface de communication (9), les valeurs de mesure de l'appareil de mesure de courant (25) et/ou de l'appareil de mesure de tension (15) peuvent être transmises par câble et/ou par radio.

4. Dispositif de mesure de puissance selon l'une des revendications précédentes 1 à 3, **caractérisé en ce qu'**il comprend un dispositif de collecte de données (17, 27, 57), par lequel les valeurs de mesure de l'appareil de mesure de courant (25) et/ou de l'appareil de mesure de tension (15) peuvent être collectées et sauvegardées.

5. Dispositif de mesure de puissance selon la revendication 4, **caractérisé en ce que** le dispositif de collecte de données (17, 27, 57) est réalisé sous forme de dispositif indépendant (57), ou est disposé dans l'appareil de mesure de courant (25) ou dans l'appareil de mesure de tension (15).

6. Dispositif de mesure de puissance selon l'une des revendications précédentes 1 à 5, **caractérisé en ce qu'**au moyen d'une sonde (28, 38, 48), on peut réaliser un couplage capacitif avec la ligne conductrice de courant (6, 7, 8), afin d'acquérir l'allure de la tension dans cette ligne (6, 7, 8).

7. Dispositif de mesure de puissance selon la revendication 6, **caractérisé en ce que** la sonde (28, 38, 48) est disposée sur le capteur de mesure de courant (21, 31, 41).
